# EUROPÄISCHE PATENTSCHRIFT

(11) **EP 0 509 112 B1**
(45) Veröffentlichungstag und Bekanntmachung des Hinweises auf die Patenterteilung: **22.01.1997**
(21) Anmeldenummer: 91106067.1
(22) Anmeldetag: 16.04.1991
(51) Int. Cl.: H03F 3/45

(54) **Ausgangpufferverstärker**
Output buffer amplifier
Amplificateur-tampon de sortie

(43) Veröffentlichungstag der Anmeldung: 21.10.1992
(73) Patentinhaber: SIEMENS AKTIENGESELLSCHAFT, 80333 München (DE)
(72) Erfinder: Koch, Rudolf, Dr., W-8052 Unterhaching (DE); Mistlberger, Fritz, W-8052 Moosburg (DE)

(56) Entgegenhaltungen:
- US-A- 4 431 972
- US-A- 4 916 338
- IEEE JOURNAL OF SOLID-STATE CIRCUITS. Bd. SC-17, Nr. 3, Juni 1982, NEW YORK US Seiten 522 - 528; M.G. DEGRAUWE ET AL: 'Adaptive Biasing CMOS Amplifiers'
- IEEE JOURNAL OF SOLID-STATE CIRCUITS. Bd. SC-17, Nr. 6, Dezember 1982, NEW YORK US Seiten 969 - 982; P.R. GRAY ET AL: 'MOS Operational Amplifier Design- A Tutorial Overview'

## Beschreibung

Die Erfindung betrifft einen Ausgangspufferverstärker

Bei der analogen Signalverarbeitung werden für eine Vielzahl von Anwendungen Ausgangspufferverstärker benötigt, wie beispielsweise zum Betreiben von Hörkapseln und Lautsprechern bei Telefonendgeräten. Die Anforderungen, die dabei an einen Ausgangspufferverstärker gestellt werden, sind u.a. die Fähigkeit niederohmige Lasten mit teilweise hohem kapazitiven Anteil zu treiben, ein großer Ausgangssignalhub bis knapp an die Betriebsspannung, eine ausreichende Linearität ohne Übernahmeverzerrungen und eine geringe Ruhestromaufnahme. Gebräuchliche Ausgangspufferverstärker sind als Endstufen der Klasse AB in CMOS-Technik mit zwei draingekoppelten komplementären MOS-Transistoren aufgeführt. Die beiden MOS-Transistoren werden von Fehlerverstärkern angesteuert, die jeweils von den gekoppelten Drain-Anschlüssen der beiden MOS-Transistoren auf einen Eingang des Fehlerverstärkers gegengekoppelt sind. Derartige Fehlerverstärker sind beispielsweise aus K.E. Brehmer und J.B. Wieser, "Large swing CMOS power amplifier", IEEE J. Solid-State Circuits, Vol. SC-18, S. 624-629, Dezember 1983; B.K. Ahuja, P.R. Gray, W.M. Baxter und G.T. Uehara, "A programmable CMOS dual channel interface processor for telecommunications applications", IEEE J. Solid-State Circuits, Vol. SC-19, S. 892-899, Dezember 1984 sowie J.A. Fisher, "A high-performance CMOS power amplifier", IEEE J. Solid State Circuits, Vol. SC-20, S. 1200-1205, Dezember 1985 bekannt.

Der von K.E. Brehmer und J.B. Wieser vorgestellte Fehlerverstärker besteht aus einer symmetrisch aufgebauten Eingangsdifferenzverstärkerstufe mit zwei sourcegekoppelten MOS-Transistoren, die über eine Stromquelle mit einem Versorgungspotential verbunden sind. Die Drainanschlüsse der beiden MOS-Transistoren sind über eine Stromspiegelschaltung an dem anderen Versorgungspotential angeschlossen. Der Ausgang der Eingangsdifferenzverstärkerstufe ist auf den Gateanschluß eines sourceseitig an dem anderen Versorgungspotential liegenden MOS-Ausgangstransistor, sowie auf den Source-Anschluß eines gateseitig an dem einen Versorgungspotential liegenden weiteren MOS-Transistors geführt. Der Drainanschluß des MOS-Ausgangstransistors ist direkt und der Drainanschluß des weiteren MOS-Transistors ist unter Zwischenschaltung eines Kondensators mit dem Gateanschluß eines der beiden MOS-Transistoren der Eingangsdifferenzstufe verbunden. Ändert sich das Potential am Drainanschluß des MOS-Ausgangstransistors in Richtung des anderen Versorgungspotentials, so verschiebt sich das Potential an den gekoppelten Source-Anschlüssen der beiden MOS-Transistoren der Eingangsdifferenzstufe in Richtung des einen Versorgungspotentials, während der Ausgang der Eingangsdifferenzverstärkerstufe in Richtung des anderen Versorgungspotentials wandert. Dadurch wird einer der beiden MOS-Transistoren der Eingangsdifferenzverstärkerstufe schon bei mittlerer Aussteuerung in den Anlaufbereich gedrückt und es wird damit die Aussteuerung des gesamten Fehlerverstärkers behindert. Der Fehlerverstärker besitzt daher nur eine geringe Gleichtaktaussteuerbarkeit.

Aus M.G. Degrauwe et al., "Adaptive Biasing CMOS Amplifiers", IEEE Journal of Solid-State Circuits, Bd. SC-17, Nr. 3, Juni 1982, Seiten 522-528, ist zudem ein direkt rückgekoppelter Endverstärker bekannt, der in jedem der beiden jeweils einem Endstufentransistor zuordenbaren Signalzweigen eine Differenzverstärkerstufe enthält, deren Ausgangssignal über einen Stromspiegel ausgekoppelt wird.

Die Patentschrift US-A 4 916 338 lehrt schließlich, die Ausgangszweige einer Differenzverstärkerstufe unsymmetrisch auszuführen und eingangsseitig Sourcefolger vorzuschalten.

Aufgabe der Erfindung ist es daher, einen Ausgangspufferverstärker der eingangs genannten Art anzugeben, der diese Nachteile nicht aufweist.

Die Aufgabe wird durch einen Ausgangspufferverstärker gemäß Patentanspruch 1 gelöst. Ausgestaltungen und Weiterbildungen des Erfindungsgedankens sind Gegenstand von Unteransprüchen.

Die Erfindung wird nachfolgend anhand des in den Figuren der Zeichnung dargestellten Ausführungsbeispiels näher erläutert, wobei gleiche Elemente mit gleichen Bezugszeichen versehen sind.

Es zeigt:
- Figur 1: ein Ausführungsbeispiel eines erfindungsgemäßen Ausgangspufferverstärkers und
- Figur 2: ein Ausführungsbeispiel eines Fehlerverstärkers bei einem Ausgangspufferverstärker nach Figur 1.

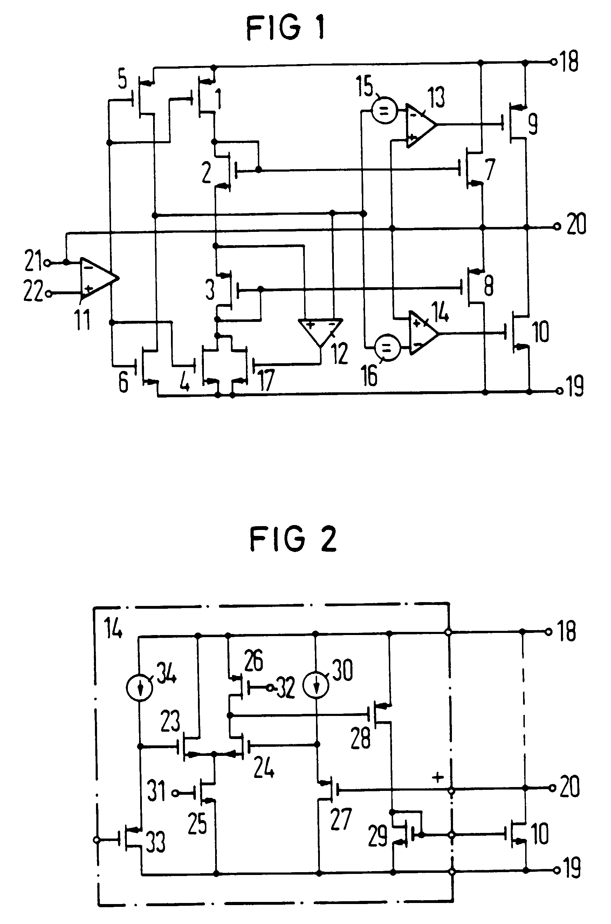

Als Ausführungsbeispiel zeigt Figur 1 einen erfindungsgemäßen Ausgangspufferverstärker mit einer Endstufe für kleine Ausgangsleistungen und einer Endstufe für große Ausgangsleistungen, deren Ausgänge miteinander verbunden sind und einen Ausgang 20 des Ausgangspufferverstärkers bilden, einer Regelstufe, die der Endstufe für kleine Ausgangsleistungen vorgeschaltet ist und deren einer Eingang durch ein einem Eingangssignal der Endstufe für große Ausgangsleistungen proportionales Signal und deren anderer Eingang durch ein einem Eingangssignal der Endstufe für kleine Ausgangsleistungen proportionales Signal angesteuert wird. Die Endstufe für große Ausgangsleistungen besteht aus einem MOS-Transistor 9 vom p-Kanal-Typ, dessen Source-Anschluß mit einem positiven Versorgungspotential 18 und dessen Drain-Anschluß mit dem Ausgang 20 verbunden ist, und aus einem MOS-Transistor 10 vom n-Kanal-Typ, dessen Source-Anschluß mit einem negativen Versorgungspotential 19 und dessen Drain-Anschluß mit dem Ausgang 20 verbunden ist. Die Gate-Anschlüsse der beiden MOS-Transistoren 9 und 10 sind an den Ausgang jeweils eines Fehlerverstärkers 13 bzw. 14 angeschlossen, deren nichtinvertierende Eingänge miteinander und mit dem Ausgang 20 verschaltet sind. Die invertierenden Eingänge der beiden Fehlerverstärker 13 und 14 sind unter Vorschalten jeweils einer Offset-Spannungsquelle 15 bzw. 16 miteinander sowie mit dem invertierenden Eingang der als Differenzverstärker 12 ausgeführten Regelstufe verbunden.

Die Endstufe für kleine Ausgangsleistungen besteht aus einem MOS-Transistor 1 vom p-Kanal-Typ, dessen Source-Anschluß mit dem positiven Versorgungspotential 18 beaufschlagt ist, und aus einem MOS-Transistor 4 vom n-Kanal-Typ, dessen Sourceanschluß mit dem negativen Versorgungspotential 19 beaufschlagt ist.

Die Drain-Source-Strecke des MOS-Transistors 4 ist die Drain-Source-Strecke eines MOS-Transistors 17 vom n-Kanal-Typ parallelgeschaltet, dessen Gate-Anschluß mit dem Ausgang des Differenzverstärkers 12 verbunden ist. Die Drain-Anschlüsse der beiden MOS-Transistoren 1 und 4 sind über eine Reihenschaltung von zwei Dioden in Durchlaßrichtung miteinander verbunden. Die beiden Dioden sind im gezeigten Ausführungsbeispiel durch einen MOS-Transistor 2 vom n-Kanal-Typ, bei dem Gate- und Drain-Anschluß miteinander sowie mit dem Drain-Anschluß des MOS-Transistors 1 verbunden sind, und durch einen MOS-Transistor 3 vom p-Kanal-Typ, bei dem Gate- und Drain-Anschluß miteinander sowie mit dem Drain-Anschluß des MOS-Transistors 4 verbunden sind, gegeben. Die Source-Anschlüsse der beiden MOS-Transistoren 2 und 3 sind miteinander gekoppelt und an den nichtinvertierenden Eingang des Differenzverstärkers 12 angeschlossen. Außerdem sind ein MOS-Transistor 7 vom n-Kanal-Typ, dessen Gate-Anschluß mit dem Drain-Anschluß des MOS-Transistors 1 und dessen Drain-Anschluß mit dem positiven Versorgungspotential 18 verbunden ist, und ein MOS-Transistor 8 vom p-Kanal-Typ, dessen Gate-Anschluß mit dem Drain-Anschluß des MOS-Transistors 4 und dessen Drain-Anschluß mit dem negativen Versorgungspotential 19 verbunden ist, vorgesehen. Die Source-Anschlüsse der beiden MOS-Transistoren 7 und 8 sind miteinander gekoppelt und bilden den Ausgang der Endstufe für kleine Ausgangsleistungen. Sie sind daher zudem an den Ausgang 20 angeschlossen.

Weiterhin ist ein MOS-Transistor 5 vom p-Kanal-Typ über seinen Drain-Anschluß mit dem invertierenden Eingang des Differenzverstärkers 12 und über seinen Source-Anschluß mit dem positiven Versorgungspotential 18 verbunden. Außerdem ist ein MOS-Transistor 6 vom n-Kanal-Typ über seinen Source-Anschluß mit dem negativen Versorgungspotential 19 und über seinen Drain-Anschluß mit dem invertierenden Eingang des Differenzverstärkers 12 verschaltet. Der Gate-Anschluß des MOS-Transistors 5 ist mit dem Gate-Anschluß des MOS-Transistors 1 und der Gate-Anschluß des MOS-Transistors 6 mit dem Gate-Anschluß des MOS-Transistors 4, die Eingänge des Ausgangspufferverstärkers bildend, gekoppelt.

Schließlich ist ein Eingangsverstärker 11 dem Ausgangspufferverstärker vorgeschaltet, der zwei Differenzeingänge 21 und 22 und zwei Differenzausgänge, die mit den Gate-Anschlüssen der MOS-Transistoren 1, 5 bzw. 4, 6 verbunden sind, aufweist.

In Figur 2 der Zeichnung ist der Fehlerverstärker 14 nach Figur 1 detailiert dargestellt. Dieser weist eine Differenzverstärkerstufe mit zwei sourcegekoppelten MOS-Transistoren 23 und 24 vom n-Kanal-Typ sowie eine Stromquelle auf. Die Stromquelle besteht dabei aus einem MOS-Transistor 25 vom n-Kanal-Typ, dessen Drain- Anschluß mit den gekoppelten Source-Anschlüssen der MOS-Transistoren 23 und 24 und dessen Source-Anschluß mit dem negativen Versorgungspotential 19 verbunden ist. An den Gate-Anschluß des MOS-Transistors 25 ist ein Biaspotential 31 gelegt.

Der Drain-Anschluß des MOS-Transistors 24, der den Ausgang der Differenzverstärkerstufe darstellt, ist mit dem Gate-Anschluß eines MOS-Transistors 28 vom p-Kanal-Typ gekoppelt, dessen Source-Anschluß an das positive Versorgungspotential 18 direkt und dessen Drain-Anschluß unter Zwischenschaltung einer Diode in Durchlaßrichtung an das negative Versorgungspotential 19 angeschlossen. Die Diode wird dabei bevorzugt durch einen MOS-Transistor 29 vom n-Kanal-Typ, bei dem Drain- und Gate-Anschluß miteinander verbunden sind, gebildet. An die miteinander gekoppelten Gateund Drain-Anschlüsse des MOS-Transistors 29 sowie an den DrainAnschlußes des MOS-Transistors 28, die den Ausgang des Fehlerverstärkers 14 bilden, ist gemäß Figur 1 der MOS-Transistor 10 angeschlossen.

In Weiterbildung der Erfindung ist mindestens einem Eingang der Differenzverstärkerstufe eine Pegelschieberstufe vorgeschaltet. Dazu ist der Gate-Anschluß des MOS-Transistors 24 zum einen über eine Stromquelle 30 mit dem positiven Versorgungspotential 18 und zum anderen über die Source-Drain-Strecke eines MOS-Transistors 27 vom p-Kanal-Typ mit dem negativen Versorgungspotential 19 verbunden. Zudem ist beim gezeigten Ausführungsbeispiel dem Gate-Anschluß des MOS-Transistors 23 eine weitere, identisch aufgebaute Pegelschieberstufe, bestehend aus einer Stromquelle 34 und einem MOS-Transistor 33 vom p-Kanal-Typ, vorgeschaltet. Der Gate-Anschluß des MOS-Transistors 27 stellt den nichtinvertierenden Eingang des Fehlerverstärkers 14 dar, während der Gate-Anschluß des MOS-Transistors 33 seinen invertierenden Eingang bildet. Gemäß Figur 1 ist der nichtinvertierende Eingang des Regelverstärkers 14 mit dem Ausgang 20 verbunden. Der in Figur 1 ebenfalls gezeigte Fehlerverstärker 13, der im weiteren nicht näher dargelegt wird, ist komplementär zu dem gezeigten Regelverstärker 14 aufgebaut.

Die Erfindung weiterbildend ist die Differenzverstärkerstufe zudem unsymmetrisch ausgeführt. Dies wird dadurch erreicht, daß der Drain-Anschluß des MOS-Transistors 23 direkt und der Drain-Anschluß des MOS-Transistors 24 über die Drain-Source-Strecke eines MOS-Transistors 26 vom p-Kanal-Typ mit dem positiven Versorgungspotential 18 verbunden ist. An den Gate-Anschluß des MOS-Transistors 26 ist ein Biaspotential 32 gelegt.

Bei dem in Figur 2 gezeigten Fehlerverstärker wird durch eine Umspiegelung des Potentials am Ausgang der Differenzverstärkerstufe auf den Gate-Anschluß des MOS-Transistors 10 erreicht, daß das Potential am Ausgang 20 und das Potential am Ausgang der Differenzverstärkerstufe, also am Drainanschluß des MOS-Transistors 24, in Gleichtakt sind. Dies wird mittels der beiden MOS-Transistoren 28 und 29 erreicht, wobei der als Diode geschaltete MOS-Transistor 29 und der MOS-Transistor 10 einen Stromspiegel bilden, der mittels des MOS-Transistors 28 von der Spannung am Ausgang der Differenzverstärkerstufe gesteuert wird. Zusätzlich wird bei der Gegenkopplung eine Pegelschieberstufe eingesetzt, damit bei negativer Aussteuerung der Differenzverstärkerstufe der Stromquellentransistor, nämlich der MOS-Transistor 25, in Sättigung bleibt. Schließlich wird durch den unsymmetrischen Aufbau der Differenzstufe verhindert, daß bei positiver Aussteuerung das Potential am Ausgang der Differenzverstärkerstufe annähernd gleich dem positiven Versorgungspotential 18 bleibt und nicht in Richtung des negativen Versorgungspotentials 19 umkippt. Mit diesen Maßnahmen wird eine viel höhere Aussteuerbarkeit des Fehlerverstärkers erreicht und damit eine optimale Ansteuerung der Ausgangstransistoren, d.h. der MOS-Transistoren 9 und 10, erzielt.

## Patentansprüche

1. Ausgangspufferverstärker mit einer Endstufe (1, 2, 3, 4, 7, 8) für kleine Ausgangsleistungen und einer Endstufe (9, 10, 13, 14, 15, 16) für große Ausgangsleistungen, deren Eingänge und Ausgänge jeweils miteinander verbunden sind und die jeweils den Signalen an ihren Eingängen entsprechende, interne Signale führen, wobei die Endstufe (9, 10, 13, 14, 15, 16) für große Ausgangsleistungen Fehlerverstärker (13, 14) zur Ansteuerung der Ausgangstransistoren (9, 10) der Endstufe (9, 10, 13, 14, 15, 16) für große Ausgangsleistungen aufweist, denen jeweils das Signal an den miteinander verbundenen Ausgängen der beiden Endstufen (1, 2, 3, 4, 7, 8; 9, 10, 13, 14, 15, 16) sowie ein internes Signal der Endstufe (9, 10, 13, 14, 15, 16) für große Ausgangsleistungen zugeführt werden und die jeweils eine Differenzverstärkerstufe (23, 24, 25) mit zwei Eingängen und einem Ausgang, einen über seinen Gate-Anschluß an den Ausgang der Differenzverstärkerstufe (23, 24, 25) und über seinen Source-Anschluß an ein erstes (18) oder zweites Versorgungspotential angeschlossenen MOS-Transistor (28) sowie ein zwischen den als Ausgang des Fehlerverstärkers vorgesehenen Drain-Anschluß des MOS-Transistors (28) und ein zweites (19) oder erstes Versorgungspotential geschaltetes, in Durchlaßrichtung betriebenes Diodenelement (29) aufweist.

2. Ausgangspufferverstärker nach Anspruch 1,
**dadurch gekennzeichnet,** daß einem Eingang der Differenzverstärkerstufe mindestens eine Pegelschieberstufe (27, 30; 33, 34) vorgeschaltet ist.

3. Ausgangspufferverstärker nach Anspruch 1 oder 2,
**dadurch gekennzeichnet,** daß die Differenzverstärkerstufe (23 bis 26) unsymmetrisch ausgebildet ist.

4. Ausgangspufferverstärker nach Anspruch 2,
**dadurch gekennzeichnet,** daß die Pegelschieberstufe jeweils aus einem als Sourcefolger geschalteten MOS-Transistor (27, 33) besteht.

5. Ausgangspufferverstärker nach Anspruch 3,
**dadurch gekennzeichnet,** daß die Unsymmetrie der Differenzverstärkerstufe (23 bis 26) durch einen mit seinem Gate-Anschluß auf einem Biaspotential (32) liegenden MOS-Transistor (26) im Ausgangskreis der Differenzverstärkerstufe (23 bis 26) erzeugt wird.

6. Ausgangspufferverstärker nach einem der Ansprüche 1 bis 5,
**gekennzeichnet durch** eine Regelstufe (12, 17), der interne Signale beider Endstufen (1, 2, 3, 4, 7, 8; 9, 10, 13, 14, 15, 16) zugeführt werden und die davon abhängig ein internes Signal der Endstufe (1, 2, 3, 4, 7, 8) für kleine Ausgangsleistungen regelt.

7. Ausgangspufferverstärker nach einem der Ansprüche 1 bis 6,
**dadurch gekennzeichnet,** daß den Signalen an den Eingängen der Fehlerverstärker Gleichspannungen (15, 16) überlagert sind.

## Claims

1. Output buffer amplifier having an output stage (1, 2, 3, 4, 7, 8) for small output powers and an output stage (9, 10, 13, 14, 15, 16) for large output powers, the inputs and outputs of which stages are respectively connected to one another and which stages in each case carry internal signals corresponding to the signals at their inputs, the output stage (9, 10, 13, 14, 15, 16) for large output powers having error amplifiers (13, 14) for driving the output transistors (9, 10) of the output stage (9, 10, 13, 14, 15, 16) for large output powers, to which amplifiers in each case the signal at the interconnected outputs of the two output stages (1, 2, 3, 4, 7, 8; 9, 10, 13, 14, 15, 16) as well as an internal signal of the output stage (9, 10, 13, 14, 15, 16) for large output powers are fed and which amplifiers in each case have a differential amplifier stage (23, 24, 25) having two inputs and one output, an MOS transistor (28), which is connected via its gate connection to the output of the differential amplifier stage (23, 24, 25) and via its source connection to a first (18) or second supply potential, as well as a diode element (29) which is operated in the forward direction and is connected between the drain connection, provided as the output of the error amplifier, of the MOS transistor (28) and a second (19) or first supply potential.

2. Output buffer amplifier according to Claim 1, characterized in that at least one level shifter stage (27, 30; 33, 34) is connected upstream of an input of the differential amplifier stage.

3. Output buffer amplifier according to Claim 1 or 2, characterized in that the differential amplifier stage (23 to 26) is of asymmetric design.

4. Output buffer amplifier according to Claim 2, characterized in that the level shifter stage in each case comprises an MOS transistor (27, 33) which is connected as a source follower.

5. Output buffer amplifier according to Claim 3, characterized in that the asymmetry of the differential amplifier stage (23 to 26) is produced by an MOS transistor (26), whose gate connection is at a bias potential (32), in the output circuit of the differential amplifier stage (23 to 26).

6. Output buffer amplifier according to one of Claims 1 to 5, characterized by a regulating stage (12, 17), to which internal signals of both output stages (1, 2, 3, 4, 7, 8; 9; 10, 13, 14, 15, 16) are fed and which, as a function thereof, regulates an internal signal of the output stage (1, 2, 3, 4, 7, 8) for small output powers.

7. Output buffer amplifier according to one of Claims 1 to 6, characterized in that DC voltages (15, 16) are superposed on the signals at the inputs of the error amplifiers.

## Revendications

1. Amplificateur séparateur de sortie, comportant un étage (1, 2, 3, 4, 7, 8) d'extrémité pour des petites puissances de sortie et un étage (9, 10, 13, 14, 15, 16) d'extrémité pour des grandes puissances de sortie, dont les entrées et les sorties sont reliées entre elles et par lesquels passent les signaux internes, correspondant aux signaux présents à leurs entrées, l'étage (9, 10, 13, 14, 15, 16) d'extrémité pour des grandes puissances de sortie comportant des amplificateurs (13, 14) d'écart, qui servent à commander les transistors (9, 10) de sortie de l'étage (9, 10, 13, 14, 15, 16) d'extrémité pour des grandes puissances, auxquels sont envoyés le signal présent aux sorties reliées entre elles des deux étages (1, 2, 3, 4, 7, 8; 9, 10, 13, 14, 15, 16) d'extrémité, ainsi qu'un signal interne de l'étage (9, 10, 13, 14, 15, 16) d'extrémité pour des grandes puissances de sortie et qui comportent chacun un étage (23, 24, 25) amplificateur différentiel comportant deux entrées et une sortie, un transistor MOS (28) qui est raccordé, par l'intermédiaire de sa borne de grille, à la sortie de l'étage (23, 24, 25) amplificateur différentiel et, par l'intermédiaire de sa borne de source, à un premier (18) ou deuxième potentiel d'alimentation, ainsi qu'un élément (29) de diode, fonctionnant dans le sens de conduction, branché entre la borne de drain, prévue comme sortie de l'amplificateur d'écart, et un deuxième (19) ou premier potentiel d'alimentation.

2. Amplificateur séparateur de sortie suivant la revendication 1, caractérisé en ce qu'il est branché au moins un étage (27, 30; 33, 34) de décalage de niveau en amont d'une entrée de l'étage amplificateur différentiel.

3. Amplificateur séparateur de sortie suivant la revendication 1 ou 2, caractérisé en ce que l'étage (23 à 26) amplificateur différentiel est dissymétrique.

4. Amplificateur séparateur de sortie suivant la revendication 2, caractérisé en ce que l'étage de décalage de niveau consiste en un transistor MOS (27, 33) monté en source suiveuse.

5. Amplificateur séparateur de sortie suivant la revendication 3, caractérisé en ce que la dissymétrie de l'étage (23 à 26) amplificateur différentiel est produite par un transistor MOS (26) du circuit de sortie de l'étage (23 à 26) amplificateur différentiel, se trouvant par sa borne de grille à un potentiel (32) de polarisation.

6. Amplificateur séparateur de sortie suivant l'une des revendications 1 à 5, caractérisé par un étage (12, 17) de régulation, auquel sont envoyés les signaux internes des deux étages (1, 2, 3, 4, 7, 8; 9, 10, 13, 14, 15, 16) d'extrémité et qui, en fonction de cela, régule un signal interne de l'étage (1, 2, 3, 4, 7, 8) d'extrémité pour de petites puissances de sortie.

7. Amplificateur séparateur de sortie suivant l'une des revendications 1 à 6, caractérisé en ce qu'il est superposé des tensions (15, 16) continues aux signaux présents aux entrées des amplificateurs d'écart.
